# EUROPEAN PATENT SPECIFICATION

(11) **EP 3 707 560 B1**
(45) Date of publication and mention of the grant of the patent: **31.12.2025**
(21) Application number: 18786339.4
(22) Date of filing: 16.10.2018
(51) Int. Cl.: G03F 7/00, B08B 7/04, B24C 1/00, B24C 3/16, G02B 27/00

(54) **METHOD FOR CLEANING**
REINIGUNGSVERFAHREN
PROCESSUS DE NETTOYAGE

(30) Priority: 07.11.2017 EP 17200266
(43) Date of publication of application: 16.09.2020
(73) Proprietor: ASML Netherlands B.V., 5500 AH Veldhoven (NL)
(72) Inventor: KUZNETSOV, Alexey, Sergeevich, 5500 AH Veldhoven (NL); BYSTROV, Kirill, 5500 AH Veldhoven (NL); BANINE, Vadim, Yevgenyevich, 5500 AH Veldhoven (NL); VAN DE KERKHOF, Marcus, Adrianus, 5500 AH Veldhoven (NL); SCHUH, Nadja, 5500 AH Veldhoven (NL); NIKIPELOV, Andrey, 5500 AH Veldhoven (NL)
(74) Representative: ASML Netherlands B.V.
(86) International application number: PCT/EP2018/078170
(87) International publication number: WO 2019/091708

(56) References cited:
- WO-A1-2017/003024
- JP-A- 2016 192 534
- US-A1- 2005 127 038
- US-A1- 2011 188 011
- US-A1- 2013 306 101
- US-A1- 2016 207 078
- US-A1- 2018 015 510
- US-A1- 2018 304 317
- US-B1- 6 173 916
- US-B1- 8 292 698

## Description

### FIELD

The present invention relates to methods for cleaning a surface to remove a metallic contaminant therefrom. In particular, the present invention relates methods for cleaning the surface of collectors for EUV lithography apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may for example project a pattern from a patterning device (e.g. a mask) onto a layer of radiation-sensitive material (resist) provided on a substrate.

The wavelength of radiation used by a lithographic apparatus to project a pattern onto a substrate determines the minimum size of features which can be formed on that substrate. A lithographic apparatus which uses EUV radiation, being electromagnetic radiation having a wavelength within the range 4-20 nm, may be used to form smaller features on a substrate than a conventional lithographic apparatus (which may for example use electromagnetic radiation with a wavelength of 193 nm).

In the lithographic apparatus, EUV radiation is generated by the ionisation of liquid tin droplets by a radiation source, such as a laser. The liquid tin droplets are passed in front of the radiation source and as the radiation hits the tin droplets, the tin droplets are ionised and release EUV radiation. The EUV radiation released by the tin droplets is released in all directions and it is therefore necessary for the EUV radiation to be focused by a collector before it can be used. One issue associated with generating EUV radiation in this way is that the tin can contaminate the collector. The tin may also contaminate the walls of the apparatus, and, although this is less of an immediate issue, it may be desirable to clean the walls from time to time. The tin may also contaminate other parts of the lithography apparatus, and it is also desirable to clean these too. Indeed, it is desirable to clean the surface of any optical element as well as sensors.

Contamination of the collector leads to a reduced reflectivity of the collector. A consequence of this is that less of the incident EUV radiation is reflected by the collector and focused, thereby reducing the power of the EUV source. Due to the reduced power of the EUV source, a longer exposure is required during lithography, which reduces the throughput of the lithographic apparatus. Similarly, if optical elements are contaminated, this will reduce their performance. If sensors are contaminated, this may adversely affect the sensitivity and/or accuracy of the sensors and may even render them inoperable. Although the cleaning of collectors used in EUV lithography apparatus is primarily discussed, it will be appreciated that the apparatus and methods disclosed herein are applicable to a wide range of surfaces to be cleaned and may be applied to optical elements, mirrors, sensors, and the like. Further, contaminants other than tin may also be cleaned from a surface using the apparatus and methods disclosed herein.

During normal usage, a collector requires cleaning around every 13 weeks. The cost of new collectors is very high and there is limited manufacturing capacity of new collectors. The production capacity is currently less than the rate at which collectors are required, so it is necessary for existing collectors to be cleaned. The removal and cleaning of a collector is a long and difficult process that requires significant skill and expertise. Therefore, collectors currently have to be sent back to the manufacturer for cleaning. It can take more than five weeks for a single collector to be cleaned. In addition, transportation can also take around three weeks. Therefore, during cleaning, a collector may be out of service for around eight weeks. It is therefore necessary to have a pool of collectors available for use. Since collectors currently require cleaning around every three months and there is around a two-month cleaning turnaround time, it is necessary to have almost double the number of collectors as lithography machines to ensure that a clean collector is available to replace the collector being used in a lithography apparatus when the collector in use becomes contaminated.

There are a number of known methods for cleaning the collector, each with its own benefits and limitations. For example, hydrogen radicals can be reacted with the tin to form tin hydride. Tin hydride has a boiling point of -52°C and is therefore a gas at temperatures at which cleaning is undertaken. Whilst this is able to clean the tin from the surface of the collector, the process is very slow and can take around a week or longer. In addition, tin hydride is a dangerous gas which can ignite on contact with air and therefore presents a significant safety hazard.

Other methods for cleaning tin from collectors include converting the deposited tin from the ductile, metallic beta allotrope of tin to the nonmetallic, alpha allotrope of tin. Alpha tin is very brittle and could be simply swept away from the surface of the collector. However, the conversion of beta to alpha tin requires a high activation energy and the process is slow. The conversion can be initiated by using low temperatures, such as minus 30°C, but such low temperatures may pose a risk to the collector itself and it is undesirable to cool the collector to such low temperatures. Using temperatures below zero could lead to the deposition of water ice on the surface of the collector. If there are any cracks on the surface of the collector, any water contained within such cracks may freeze and expand, thereby damaging the surface of the collector, which could lead to decreased performance of the collector. In addition, the collectors comprise cooling channels which may contain water for use in cooling. If temperatures below 0°C are used, this may lead to the formation of ice in the cooling channels, which could also damage the collector. Further, the use of very low temperatures may result in distortions of the surface due to the differential contraction and/or expansion of the surface.

It is also possible to clean surfaces such as collectors using various chemical methods. For example, it has been proposed to apply hydrochloric acid to the surface of the collector in order to react it with the tin contaminant. However, this is a time consuming process and there is risk to an operator in using strong acids and also a risk of inadvertent damage to the collector. Further, the deposits on the surface to be cleaned are not always solely comprised of tin and other metals or non-metals may be present. Therefore, in order to ensure that the surface is as clean as possible, multiple chemical cleaning methods may be required. However, this has the disadvantage of essentially selectively etching the surface of the collector. The chemical cleaning methods may not only remove the unwanted material, such as tin or other metals or non-metals, from the surface of the collector, but may also remove materials comprising the collector itself. Collectors are very complex multi-layered mirrors with finely tuned refractive indices on each layer. Thus, if the metals which are used to form the various layers of the mirror are selectively etched from the layers, this may alter the refractive index of the layer or otherwise damage the surface. Whilst this may be acceptable if only one chemical cleaning method were used, since a number of different chemical cleaning methods are required, this will result in an increased amount of damage to the collector in a short period of time.

Other methods for cleaning collectors, such as polymer film peeling, are known. However, these other methods can be slow, expensive, and/or have safety concerns.

It is known to use carbon dioxide snow to clean a wide variety of surfaces. Carbon dioxide can be used to clean surfaces via three different methods, namely using macroscopic dry ice pellets, snow streams spraying the surface to be cleaned with either microscopic or macroscopic carbon dioxide snow particles, or by using supercritical carbon dioxide.

In systems which use macroscopic dry ice pellets, cleaning is achieved by abrasive action and momentum transfer. The pellets are able to physically dislodge surface contaminants and the sublimation of the solid carbon dioxide (commonly referred to as 'dry ice') into gaseous carbon dioxide is able to push contaminants from the surface to be cleaned.

In systems which use supercritical carbon dioxide, the low viscosity of the supercritical fluid means that it is able to enter tight spaces where it can dissolve contaminants. Supercritical carbon dioxide is able to dissolve organic contaminants readily and is therefore used in the extraction of caffeine from coffee beans or nicotine from tobacco.

In systems which rely on carbon dioxide snow, the snow is generated by passing either liquid or gaseous carbon dioxide through an orifice. The drop in pressure as the liquid or gaseous carbon dioxide passes though and out of the orifice causes at least some of the carbon dioxide to solidify to form carbon dioxide "snow".

The use of snow cleaning is standard in many industries, such as the food industry and the manufacturing industry. However, it has not been used to remove metallic deposits, in particular tin deposits, from lithography equipment, particularly collectors or mirrors. Furthermore, known methods of and conditions used in carbon dioxide snow cleaning have been surprisingly found to be sub-optimal. Further, it has also been surprisingly found that carbon dioxide snow cleaning is particularly suitable for cleaning metallic contamination from a mirror, whereas previously it has only been used to clear off materials which are only loosely adhered to the surface to be cleaned or which are not in themselves particularly robust, such as paint.

**In** known snow cleaning apparatus, the carbon dioxide is passed out of a central nozzle which causes the carbon dioxide snow to form. Surrounding the central nozzle, there may be provided an annular flow of clean, dry air which assists in directing the flow of the carbon dioxide snow. In this way the flow of carbon dioxide snow is surrounded by an annular curtain of clean, dry air.

Due to the very low temperature of the carbon dioxide snow, there is a risk that if the carbon dioxide snow is directed to a portion of a surface for too long, this could result in overcooling, which could lead to damage due to water ice formation or possible distortion of the surface due to the differential contraction of one portion of the surface relative to another portion. Further, in the event of water ice formation, this may result in the carbon dioxide cleaning apparatus only cleaning off the water ice rather than the contaminants which were the reason for the cleaning. In carbon dioxide snow cleaning, it is preferable to have the outlet of the nozzle as close to the surface to be cleaned as possible, typically from about 5 to about 10 mm from the surface as this has been found to provide the best cleaning results. Further, it is also desirable to direct the carbon dioxide snow stream at a shallow angle to the surface to be cleaned so that the flow of the carbon dioxide snow stream will tend to push away any loosened material from the surface. The surface of the collector is also very sensitive to damage and any inadvertent contact of the carbon dioxide snow cleaning apparatus may result in damage to the collector.

Whilst carbon dioxide snow cleaning has been found to be suitable for cleaning lithographic apparatus, it has been found to be less effective at cleaning very thick layers of contaminants, such as tin, as well as firmly attached contaminants, such as tin drips or spits of tin.

Furthermore, current methods for removing particles or other contaminants from components of a lithographic apparatus, such as manual wiping and vacuum cleaning, may not be adequate to meet the very high cleanliness requirements. This may be because particles or other contaminants in crevices, grooves, orifices and the like are not removed, and it may be because it is not possible to ensure uniformity of cleaning over large surfaces. Further, access to some surfaces may be difficult meaning that these may not be adequately cleaned using existing methods and apparatus.

Contaminants and particles in a lithography apparatus are not just limited to tin and there are multiple potential sources of contaminants. For example, wafers may comprise contaminants that are transferred to the wafer table and particles between the burls which hold wafers in place can lead to clamping distortion and overlay or focus errors. Particles may also be generated during polishing or planarization of burls and it may be difficult to remove such contaminants.

It is believed that particles falling on a dynamic gas lock membrane could increase the likelihood of the membrane rupturing. It is therefore desirable to provide a cleaning method and apparatus which addresses one or more of these issues.

Existing cleaning methods using carbon dioxide pose a risk of asphyxiation of the operator when done in the open air due to the release of carbon dioxide gas into the surrounding atmosphere. Although it has been proposed to provide a gas evacuation nozzle to withdraw the carbon dioxide and contaminants after they have been dislodged, this causes air to enter the apparatus and this air may contain contaminants and thereby reintroduce contaminants to the surface which has been cleaned, Further, since carbon dioxide cleaning uses low temperatures, it is necessary to heat the surface after cleaning or to allow additional time for the surface to warm back up to ambient temperatures otherwise water vapour may condense on the surface trapping particles and preventing further cleaning.

US 2013/0306101 A1 discloses a cleaning of a substrate including a reactive species generator and a CO₂ snow generator. CO₂ snow cleaning alone preferentially removes inorganic defects, while the reactive species preferentially remove organic defects.

US 2005/0127038 A1 discloses a method of removing polymeric residue (photoresist) from an integrated circuit structure. Free radicals generated from one or more reactant gases react with the polymeric residue. Polymeric residue present after the free radicals react with the polymeric residue is removed with carbon dioxide snow that is emitted from a nozzle.

WO 2017/003024 A1 discloses a CO₂ snow spray type cleaning device which includes a liquid carbon dioxide transfer pipe arranged concentrically in a CDA carrier gas inlet pipe, and a foreign material suction part positioned to surround the carrier gas inlet pipe to suck and remove foreign materials generated during a cleaning.

US 8292698 B1 discloses a method of cleaning contaminants from an interior surface in a plasma chamber, by blasting with dry ice mixed with CDA to remove contaminants from the surface. A vacuum hose positioned with its inlet opening by the side of the dry ice blast applicator removes contaminants cleaned from the surface.

US 2011/0188011 A1 discloses a method of cleaning an optical surface of an optical element arranged in a vacuum chamber. A cleaning device is configured to perform particle cleaning of the optical surface at a gas pressure within the vacuum chamber which is higher than a vacuum pressure for performing an exposure operation with the projection exposure apparatus. The particle cleaning device is configured to perform the particle cleaning by at least one cleaning method selected from the group consisting of: snow cleaning, in particular using carbon dioxide, argon, or nitrogen, laser shockwave cleaning, air knife cleaning, magnetic field cleaning, high voltage cleaning, plasma assisted cleaning, temperature assisted cleaning, and the use of an adhesion foil or a polymeric peel-off layer.

Whilst the present application generally refers to EUV lithography apparatus throughout and particularly collectors, the invention is not limited to solely EUV lithography apparatus and it is appreciated that the subject matter of the present invention may be used to clean any surface of any lithography apparatus, in particular any optical element, mirror, reflective surface, wall, and sensor or similar in the lithography apparatus.

### SUMMARY

The present invention has been made in consideration of the aforementioned problems with known methods of cleaning lithography apparatus, in particular EUV lithography apparatus and even more particularly, optical elements of EUV lithography apparatus, including mirrors, reflective surfaces, collectors, walls, and sensors used in EUV lithography apparatus.

According to the present invention, there is provided a method of cleaning a surface to remove a metallic contaminant therefrom, as defined in claim 1. The present invention refers to "metallic contaminants"; in the following description, this feature is referred to as "contaminants." Nonetheless, the term "contaminants" does not exclude optional supplemental presence of metal compounds, and/or semi-metals or non-metals as well as compounds thereof.

It has been found that it is difficult to remove thick layers of contaminants, such as tin, using carbon dioxide snow cleaning techniques by themselves. Whilst carbon dioxide snow cleaning has been found to be suitable to remove loose contaminants and relatively thin layers of contaminants from a surface, strongly adhered contaminants and thick layers of contaminants are more difficult to remove. It has been surprisingly found that if cleaning is stopped after a first cleaning cycle and the surface to be cleaned is then left for a period of time, and the carbon dioxide snow cleaning is then continued, strongly adhered contaminants and relatively thick layers of contaminants can be removed. Without wishing to be bound by scientific theory, it is believed that the contaminant may be protected by an oxide layer. During the first cleaning cycle, the oxide layer is removed by the carbon dioxide snow, and the underlying layer is exposed. Oxidizing the newly exposed underlying layer makes the contaminant more susceptible to being removed when a subsequent carbon dioxide snow cleaning cycle is employed. It is believed that the oxidation of the contaminant alters the stress in the contaminant and weakens the adhesion of the contaminant to the surface to be cleaned.

Preferably the contaminant comprises tin. Since liquid tin is used in the production of EUV radiation in EUV lithographic apparatus, the contaminant mainly comprises tin. Even so, it will be appreciated that the contaminant may comprise elements other than tin, and may comprise one or more metals, semi-metals, or non-metals as well as compounds thereof.

The contaminant may be oxidized by any suitable means. The contaminant may be at least partially oxidized by merely exposing the contaminant to air. The oxygen in the air will react with the contaminant to form an oxide layer. The oxide layer may passivate the surface and stop further oxidation from occurring in the bulk of the contaminant. Thus, it may be necessary to provide multiple cycles of oxidation and cleaning in order to remove the contaminant from the surface.

The contaminant may be at least partially oxidized by exposure to plasma. As such, a plasma stream may be directed onto the contaminant. The plasma may be atmospheric plasma. Atmospheric plasma is plasma in which the pressure is substantially the same as the pressure of the surrounding atmosphere. The use of atmospheric plasma is advantageous as no reaction vessel is required to produce a partial vacuum, as required by low-pressure plasma, or to contain high-pressure plasma. An atmospheric plasma stream may be passed across the contaminant in order to oxidise at least a portion of the contaminant. The atmospheric plasma stream may be passed through a plasma nozzle or outlet. Preferably, the plasma comprises oxygen. The gas used to form the plasma may be air. The surface of the collector is insensitive to oxidation, so only contaminants will be oxidized and removed from the surface, leaving the surface undamaged by the cleaning process and ready for use. The source of the air used for the plasma may be a source of clean, dry air. The clean, dry air use in the production of the plasma may be the same as the clean, dry air used in the carbon dioxide snow cleaning. A combination of atmospheric oxidation and plasma oxidation may be used.

At least a portion of the contaminant may be oxidized prior to carbon dioxide snow cleaning. After the carbon dioxide snow cleaning cycle, the contaminant may be oxidized once again. The steps of oxidizing at least a portion of the contaminant and cleaning with carbon dioxide snow may be repeated any suitable number of times.

The surface to be cleaned is advantageously cleaned with carbon dioxide snow prior to the oxidation step. In this way, any existing oxide layer may be removed from the contaminant, thereby exposing a non-oxidized layer. The non-oxidized layer is then oxidized. In this way, the oxidation step may be more efficient as there is no passivating oxide layer already present on the surface of the contaminant.

The method of the present invention may be carried out until the surface is sufficiently clean to be put back into use. For example, this may mean that all of the contaminant has been removed, or a property of the surface, such as absorbance or reflectivity, has been restored to a predetermined level that allows the surface to be used for its intended purpose. The extent to which a surface must be cleaned of contaminants will depend on the surface being cleaned. For example, the surface of a reflector is likely to require that as many of the surface contaminants as possible are removed, whereas a surface which is not required to reflect radiation, such as a wall of a lithographic apparatus, is likely to require less stringent cleaning.

Loose debris on the surface to be cleaned may be removed from the surface prior to the oxidation and/or carbon dioxide snow cleaning steps. The loose debris may be removed by any suitable means. For example, the loose debris may be removed by brushing, cleaning with a solvent, by blowing on the surface with a gas, such as air, or by passing carbon dioxide snow over the surface. The solvent may be water, an organic solvent, an inorganic solvent, or mixtures of different solvents.

The carbon dioxide snow cleaning step may comprise passing a stream of carbon dioxide out of a carbon dioxide nozzle or outlet to form a carbon dioxide snow stream. It may also comprise providing a stream of gas which substantially surrounds the carbon dioxide snow stream, directing the streams of gas and carbon dioxide snow onto the surface to be cleaned, and passing the streams of gas and carbon dioxide snow over the surface to be cleaned.

The distance between the carbon dioxide snow nozzle or outlet and the surface may be from around 20 mm to around 100 mm.

The carbon dioxide snow nozzle may be separated from the surface by from around 40 mm to around 80 mm, preferably around 55 mm to around 65 mm, and most preferably around 60 mm. The size of the opening of the carbon dioxide snow nozzle may vary depending on the required operating conditions.

It is known in the art that the nozzle or outlet from which the carbon dioxide snow is released should be kept as close to the surface to be cleaned as possible, and is usually held at a distance of from about 5 mm to about 10 mm from the surface. However, it has been surprisingly realized that having the nozzle further away from the surface results in improved cleaning performance. It is also known that carbon dioxide snow cleaning can be used to clean organic materials, such as oil or grease, from a surface and to also remove particles which are loosely attached to the surface. However, it was not appreciated that carbon dioxide snow cleaning could be used to remove metallic contaminants from the surface of a mirror. In an example of the present disclosure, the nozzle is held at a distance of around 40 mm to around 80 mm from the surface to be cleaned, more preferably around 50 mm to around 70 mm from the surface to be cleaned, and most preferably around 60 mm from the surface to be cleaned. Without wishing to be bound by scientific theory, it is believed that the greater distance between the nozzle and the surface to be cleaned allows the carbon dioxide snow to be accelerated to a higher velocity and thereby strike the surface with a higher energy. Alternatively or additionally, the morphology of the carbon dioxide snow may change over greater distances, which also results in improved cleaning performance. An additional benefit of using a greater distance between the carbon dioxide snow nozzle and the surface to be cleaned is that there is a greater margin of error which reduces the likelihood of the nozzle coming into direct contact with the surface, thereby damaging the surface. Furthermore, again without wishing to be bound by scientific theory, it is believed that the carbon dioxide snow stream may reach its optimal shape at the distances disclosed herein. As the carbon dioxide snow stream is accelerated by the gas stream, it is also shaped and focused to provide the most effective cleaning result.

The angle subtended between the surface to be cleaned and the direction of the carbon dioxide snow stream may be from around 45°to around 90°.

Preferably, the angle subtended between the surface to be cleaned and the direction of the carbon dioxide snow stream is greater than around 60°, preferably greater than around 75°, and most preferably substantially around 90°. The angle subtended between the surface to be cleaned and the direction of the carbon dioxide snow stream may be varied during or between cleaning cycles or passes. For example, the angle may initially be around 90° for a first portion of a cleaning cycle. The angle may then be varied to a shallower angle, for example 50° degrees for a second portion of the cleaning cycle. The angle may then be varied to yet another angle or back to the original angle for a further portion of the cleaning cycle. In this way, the angle may be alternated during or between cleaning cycles.

It is also known in the art that the angle at which the carbon dioxide is directed against the surface to be cleaned should be a low or shallow angle. In particular, the angle subtended between the surface and the direction at which the carbon dioxide snow is directed to the surface is generally around 30° or less. The lowest angle is 0° since this represents the carbon dioxide snow being directed parallel to the surface to be cleaned. It is considered that a low or shallow angle is preferable as any contaminants which are dislodged from the surface are pushed away by the direction of flow of the stream of carbon dioxide snow. However, against what is known in the art, it has been surprisingly discovered that using a higher angle results in improved cleaning of the surface, in particular when metallic contaminants are to be removed from the surface of a mirror. As such, the angle subtended between the surface and the direction at which the carbon dioxide snow is directed to the surface is preferably around 45° or more. In this context, the greatest angle will be 90°, which represents the case where the stream of carbon dioxide snow is directed at the normal to the surface, i.e. perpendicular to the surface. In other examples, the angle is preferably greater than around 60°, more preferably more than around 75, and most preferably around 90°.

It will be appreciated that the carbon dioxide snow stream will have a particular width. The skilled person will appreciate that the angle will be measured from the central line of the stream and that there is a degree of uncertainty in the measurements, such that slight deviations from the angles disclosed herein are also within the scope of the disclosure.

The stream of gas which substantially surrounds the carbon dioxide snow stream is heated to from around 20°C to around 80°C, preferably from around 30°C to around 70°C, more preferably from around 40°C to around 65°C, and even more preferably to around 50°C. The collector may also be heated by other means. The collector may be heated to from around 20°C to around 80°C, preferably from around 30°C to around 70°C, more preferably from around 40°C to around 65°C, and even more preferably to around 50°C. By heating the collector, any surface contaminants are also heated. Therefore, when the carbon dioxide stream passes over the contaminants, the difference in temperature is greater than would otherwise be the case and the cleaning performance is improved. This also reduces the risk of overcooling of the collector, which could result in damage to the collector.

The stream of carbon dioxide snow is preferably provided by at least one carbon dioxide snow outlet or nozzle. Preferably, the carbon dioxide stream is provided by a plurality of carbon dioxide snow outlets. A single outlet will define a cleaning area over which the carbon dioxide snow is able to clean the surface. In order to cover a larger proportion of the surface to be cleaned, multiple carbon dioxide snow outlets may be used.

The at least one carbon dioxide snow outlet may be provided on an arm. The arm supports the at least one carbon dioxide snow outlet and holds it in the desired orientation.

The arm may be rotatable. As such, when the surface is being cleaned, the arm may be rotated. This rotation causes the at least one carbon dioxide snow outlet to pass over the surface which is being cleaned in a circular path.

In another embodiment, the arm is stationary and the surface to be cleaned is rotated. The effect of keeping the arm stationary whilst the surface is rotated has the same effect as keeping the surface stationary whilst moving the carbon dioxide snow outlets. However, in the case where the carbon dioxide snow outlets are stationary, the plumbing required is simplified as there is no need to provide any means to avoid the pipes carrying the carbon dioxide from the carbon dioxide source from becoming tangled. In addition, there may be additional pipes to feed the plasma outlets and/or the outlets for the gas which surrounds the carbon dioxide snow outlet, which add to the complexity of the plumbing.

By being able to rotate the arm and/or the surface to be cleaned, it is possible make multiple passes over the same part of the surface. The rate at which the arm and/or the surface are rotated may be selected depending on the surface being cleaned and the degree of cleaning required. The cleaning method of the present invention has been found to be around 10 to 100 times as fast as previous cleaning techniques.

The arm and/or the surface to be cleaned may be rotated in a single direction or may be rotated in both forward and backward directions. The arm and/or the surface may oscillate between rotating in one direction and rotating in the opposite direction. The arm and/or the surface may contra-rotate relative to one another.

The arm and/or the surface may rotate by any amount. For example, they may rotate through any suitable number of 360° rotations. Alternatively, especially but not only where there is a plurality of arms, the arms and/or the surface may rotate through a distance in one direction, and then reverse direction. For example, where the arms extend across the entire diameter of the surface to be cleaned, in a single 360° rotation, any given point on the surface will pass under the arm twice. Therefore, if it is desirable to only pass a given point under the carbon dioxide snow outlet once, it is possible to rotate through around 180° before reversing.

The rotation of the arm and/or the surface to be cleaned may be eccentric. The eccentric motion assists in ensuring that the entirety of the surface to be cleaned is contacted by the carbon dioxide snow. Additionally or alternatively, the arm and/or the surface may be movable in the plane perpendicular to the axis of rotation. For example, where the axis of rotation corresponds to the z-axis, the arm and/or the surface may be movable in the x and/or y directions. Again, this ensures that the entire surface is contacted by the carbon dioxide snow. The arm and/or the surface to be cleaned may be moved such that the carbon dioxide snow outlet is moved relative to the surface to be cleaned and vice versa. For example, the arm and/or the surface may be moved such that there is an offset between consecutive cleaning passes or cycles. The offset will depend on the size and number of carbon dioxide/plasma outlets, but may be in the order of less than around 10 mm, less than around 5 mm, less than around 1 mm, and preferably around 0.5 mm. As such, the area onto which the carbon dioxide snow stream is directed may be moved between cleaning cycles or passes. This ensures that the whole of the surface is cleaned equally.

The arm and/or the surface to be cleaned may be movable to vary the distance between the at least one carbon dioxide outlet and the surface to be cleaned. For example, where the axis of rotation corresponds to the z-axis, the arm and/or the surface to be cleaned may be movable along the z-axis. By varying the distance between the carbon dioxide snow outlet and the surface to be cleaned, the apparatus can be tuned to provide optimal cleaning performance.

The at least one carbon dioxide snow outlet may be positioned adjacent the at least one plasma outlet. As such, the outlets may be in a side-by-side configuration. The at least one plasma outlet may be positioned in line with the at least one carbon dioxide snow outlet. Where the at least one plasma outlet is positioned in line with the at least one carbon dioxide snow outlet, in one direction of rotation, a contaminant on the surface passes through the plasma first where it is at least partially oxidized and then through the carbon dioxide snow, which removes at least a portion of the contaminant. In the other direction of rotation, the contaminant is cleaned by the carbon dioxide snow first, which removes the existing oxide layer from the contaminant, which allows the plasma to more readily oxidise the contaminant.

The at least one carbon dioxide snow outlet and the at least one plasma outlet may be positioned on the same and/or on different arms. For example, one arm may solely comprise carbon dioxide snow outlets and another arm may comprise solely plasma outlets.

The method of the invention may further comprise passing a stream of ultrasonically activated liquid over the surface to be cleaned. The ultrasonically activated liquid may be an aqueous liquid. The ultrasonically activated liquid may be acidic or alkaline. Preferably, the ultrasonically activated liquid is acidic. Preferably, the acid is hydrochloric acid, although the skilled person will recognize that any acid which reacts with the contaminant but does not react or only slowly reacts with the surface to be cleaned would be suitable.

The liquid may be ultrasonically activated by putting the liquid in communication with an ultrasonic acoustic transducer.

The ultrasonic acid cleaning may take places instead of or in addition to the carbon dioxide snow cleaning and/or the oxidation steps.

The acoustic transducer causes pressure fluctuations to be generated at the surface to be cleaned. It has been surprising found that the combination of hydrochloric acid and the pressure fluctuations results in an improved performance over what would be expected from the combination of the two.

By having an ultrasonic transducer in communication with the hydrochloric acid stream, when the hydrochloric acid stream is directed onto a surface to be cleaned, the ultrasonic transducer produces pressure fluctuations at the surface, which serve to enhance the cleaning ability of the hydrochloric acid. The combination of hydrochloric acid and the pressure fluctuations result in improved cleaning performance over what would be expected. The pressure fluctuations create small bubbles inside the liquid which help remove the contaminants from the surface.

The ultrasonically activated acid cleaning is suitably combined with carbon dioxide snow cleaning and/or plasma oxidation. Where ultrasonic cleaning is combined with carbon dioxide snow cleaning and/or oxidation, the resulting cleaning achieved is surprisingly better than would be expected when using just one of these techniques alone.

The method may employ an apparatus for cleaning a surface, the apparatus comprising at least one carbon dioxide snow outlet, and at least one plasma outlet.

The plasma outlet is able to provide a plasma beam which oxidises contaminants on the surface to be cleaned. Without wishing to be bound by scientific theory, it is believed that the oxidation weakens the structure of the contaminant and makes it easier for the carbon dioxide snow to remove the contaminant from the surface.

The at least one carbon dioxide snow outlet and/or the at least one plasma outlet may be connected to an arm.

The arm may be rotatable. In this way, the surface to be cleaned may be kept stationary whilst the arm is rotated.

Alternatively, the arm may remain stationary and the surface to be cleaned may be rotatable.

Alternatively, both the arm and the surface to be cleaned may be rotatable.

The apparatus may comprise a support for the object being cleaned. The support may be in the form of a cradle for an EUV collector. The support may be rotatable. The rotation may be effected by any suitable means, such as an electric motor. The rate of rotation may be controlled by any suitable controller.

The apparatus preferably comprises a plurality of carbon dioxide snow outlets and/or a plurality of plasma outlets. The carbon dioxide snow outlets are preferably arranged to substantially correspond to the shape of the surface to be cleaned. The arm is preferably shaped to substantially reflect the shape of the surface to be cleaned. For example, where the surface to be cleaned is an EUV collector, the outlets are arranged such that the distance from the outlets to the surface is substantially the same for all outlets. This ensures that the optimal distance between the outlet and the surface is maintained for each outlet, thereby allowing optimal cleaning.

The apparatus may comprise more than one arm. The arms can be provided in any suitable configuration. For example, the arms may extend across substantially the entire diameter of the surface to be cleaned or may be in a cross or X-shape. It will be appreciated that any suitable number of arms may be used. It will also be appreciated that the arms can be arranged in any suitable configuration. It is preferable that the arms are radially evenly spaced, although it is possible for the arms to be unevenly spaced.

The carbon dioxide snow outlets may be of any suitable shape. The outlets may be substantially circular or may be in the shape of a slit. It will be appreciated that any suitable outlet shape may be used and that different outlet shapes may be used in the same apparatus. Where the outlet is in the shape of a slit, there may be a plurality of outlets, or there may be a single outlet extending substantially the length of the arm and/or the surface to be cleaned. The advantage of using slits is that the carbon dioxide snow which is passed out of the outlet extends along a greater length than when it is passed out of a circular orifice, and there are no 'dead' areas between adjacent outlets over which no carbon dioxide snow may be passed. Where there are adjacent circular outlets, there may be a zone of clean dry air between neighbouring carbon dioxide snow streams which results in a region under the arm where the surface is not cleaned. This is avoided by the use of a slit.

Preferably, the apparatus comprises a plurality of plasma outlets. Preferably, the plasma is atmospheric plasma. The plasma is able to oxidise the contaminant, which makes it easier for the carbon dioxide snow to remove the oxidized layer in order to clean the surface.

The plasma may comprise oxygen. The source of the gas used to generate the plasma may be any gas comprising oxygen. For example, clean, dry air may be used to generate the plasma. Alternatively, pure oxygen or a mixture of oxygen with another gas or gases may be used.

The plasma outlets may be located at any suitable part of the apparatus. The plasma outlets may be located next to the carbon dioxide snow outlets, either side-by-side or one in front of the other. Alternatively, the plasma outlets may be located remote from the carbon dioxide snow outlets. Where there is a plurality of arms, the plasma and carbon dioxide snow outlets may be located on different arms. Alternatively, they may be located on the same arm. As with the carbon dioxide snow outlets, the plasma outlets may be substantially circular or may be in the shape of a slit. The skilled person would of course recognize that any suitable shape may be used.

The flows of carbon dioxide snow and plasma can be turned on and off as required. As such, the apparatus further comprises means for turning the carbon dioxide snow outlets and the plasma outlets on or off, for example one or more valves. The valves may be partially opened to allow for fine control of the rates of flow of the carbon dioxide snow and/or the plasma. For example, both flows may be on simultaneously, or one flow may be on continuously with the other flow being turned on and off intermittently as required. In another example, only one of the flows may be turned on at a given time. Where there is contamination on only a particular portion of the surface, the carbon dioxide snow outlets and the plasma outlets can be controlled such that only the ones which are required to clean the contamination are turned on.

The length of time each flow is turned on will be adjusted to provide optimal cleaning. For example, where the carbon dioxide snow cleaning step is faster than the oxidation step, the carbon dioxide snow flow may only need to be turned on for less time than the atmospheric plasma flow is turned on. In the case where the oxidation step is faster than the carbon dioxide cleaning step, the atmospheric plasma flow may be turned on for a shorter time than the carbon dioxide snow flow.

In an example, the arm is in the form of a plate. Preferably the plate is shaped to substantially correspond to the shape of the surface to be cleaned. In the plate, there is a plurality of holes in which the plurality of carbon dioxide snow outlets and/or the atmospheric plasma outlets are located. In this way, the outlets form a 'shower head'. As with the other examples and embodiments described herein, the outlets are distributed across the plate such that when the plate and/or the surface to be cleaned is rotated, substantially the entire surface is cleaned.

The apparatus may comprise a heater to heat the gas stream which substantially surrounds the carbon dioxide gas stream

The heater may be selected to allow it to provide a gas stream at temperatures of from around 20°C to around 80°C, preferably from around 30C to around 70°C, more preferably from around 40°C to around 65°C, and even more preferably to around 50°C.

Due to the different coefficients of expansion between the surface and the contaminant, the strength of the bond between the surface and the contaminant is reduced when the contaminant is exposed to the carbon dioxide snow. As the apparatus continues to pass across the surface, the much colder carbon dioxide snow stream is directed onto the area which has just been heated by the gas stream. The contaminant has a lower thermal mass and therefore contracts more quickly than the surface, which further serves to loosen the contaminant from the surface. As the apparatus further continues to move across the surface, the gas stream then passes across the area which has been cooled by the carbon dioxide snow stream. This heats the area up and stops the temperature of the area from dropping too far and also ensures that no water condenses on the surface. A further benefit of the heated gas stream is that is provides a protective gas layer which is essentially free from water. As such, any moisture which is present on the surface is removed by the heated gas stream before the surface is cooled by the carbon dioxide snow stream. This reduces the possibility of any liquid water or water ice forming on the surface and either damaging the surface or reducing the effectiveness of the cleaning procedure. The gas stream may comprise air, or may comprise any other suitable gas, such as nitrogen. Preferably, the gas stream is substantially dry. Preferably the gas is clean and substantially free of contaminants, such as dust, particles, organic and inorganic compounds, and the like.

The pressure of the gas stream may be from around 1 bar to around 20 bar, more preferably from about 5 bar to about 15 bar, and most preferably substantially about 10 bar.

The outlet through which the gas substantially surrounding the carbon dioxide stream passes out of may be of any suitable shape to provide a gas stream which substantially surrounds the carbon dioxide snow stream. The gas stream may be provided through a single outlet which substantially surrounds the carbon dioxide nozzle. However, the gas stream may be provided by more than one outlet. The gas stream outlet and the carbon dioxide nozzle may be concentric. The gas comprising the gas stream may be any suitable gas. Preferably, the gas is air, although it will be appreciated that any other suitable gas, such as nitrogen, may be used. Preferably the gas is substantially dry. Preferably the gas is clean and substantially free of contaminants, such as dust, particles, organic and inorganic compounds, and the like.

Preferably, the carbon dioxide nozzle is concentric with the gas stream. The gas stream is provided from any suitable source.

Preferably, the carbon dioxide source comprises liquid carbon dioxide, although it is appreciated that any suitable carbon dioxide source may be used. Where the carbon dioxide source comprises liquid carbon dioxide, the carbon dioxide may be held at a pressure of around 50 to 70 bar, preferably around 60 bar. However, it will be appreciated that the exact pressure of the carbon dioxide source can be selected depending on the design of the nozzle and the required pressure of the carbon dioxide snow. When the carbon dioxide leaves the nozzle, the pressure will drop to substantially atmospheric pressure. Due to the rapid expansion of the carbon dioxide, the carbon dioxide will form carbon dioxide snow, which can then be used for cleaning.

The apparatus may comprise one or more acid outlets in addition to the carbon dioxide snow and/or atmospheric plasma outlets.

The one or more acid outlets may be arranged and controlled in the same way as the carbon dioxide snow and/or plasma outlets. The acid may be any suitable acid. For example, the acid may be hydrochloric acid. A suitable acid is one which is able to react with the contaminant to be removed, such as tin, but which is substantially inert to the surface to be cleaned and therefore does not damage the surface when used or which reacts with the surface considerably more slowly than it reacts with the contaminant. The acid reacts with the contaminant to form compounds which are more easily removed from the surface to be cleaned.

Preferably, the acid stream is in communication with an acoustic transducer. The acoustic transducer may be ultrasonic.

The acoustic transducer causes pressure fluctuations to be generated at the surface to be cleaned. It has been surprising found that the combination of hydrochloric acid and the pressure fluctuations results in an improved performance over what would be expected from the combination of the two.

The stream of hydrochloric acid may be passed from an ultrasonic-activated liquid gun, such as that sold under the name Starstream^{™} by Ultrawave Precision Ultrasonic Cleaning Equipment Limited.

The hydrochloric acid is preferably an aqueous solution of hydrogen chloride. The molarity of the solution can be varied depending on the particular cleaning requirements and the required concentration may be determined routinely.

The surface to be cleaned may be the surface of a component of a lithographic apparatus. The surface may be the surface of a collector or other reflective surface in a lithographic apparatus. Preferably, the lithographic apparatus is an EUV lithography machine, although in some examples, it may be any other type of lithographic machine. The surface to be cleaned may be any other surface of an EUV lithography machine or other lithography machine, for example any optical element, mirror, collector, sensor, or the like.

There is further provided a cleaning head comprising at least one carbon dioxide snow outlet and at least one plasma outlet.

It has been surprisingly realized that the combination of a plasma outlet and a carbon dioxide snow outlet can lead to improved cleaning results than would be expected from the combination of the two individual outlets alone. The plasma outlet is able to provide plasma which oxidises contaminants on a surface to be cleaned and the carbon dioxide snow outlet is able to provide carbon dioxide snow to remove the oxidized layer from the surface to be cleaned.

The plasma outlet and the carbon dioxide snow outlet may be in any suitable configuration. In one configuration, the plasma outlet substantially surrounds the carbon dioxide snow outlet. In an alternative configuration, the carbon dioxide snow outlet substantially surrounds the plasma outlet.

The cleaning head may further comprise a gas outlet. The gas outlet may be located in any suitable position. In one configuration, the gas outlet substantially surrounds the carbon dioxide snow outlet. The gas outlet may be intermediate the carbon dioxide snow outlet and the plasma outlet. The gas outlet and the carbon dioxide snow outlet may form a nozzle separate to the plasma outlet, which may form its own nozzle. The gas outlet, carbon dioxide snow outlet, and the plasma outlet may be substantially concentric. One or more of the gas outlet, carbon dioxide outlet, and the plasma outlet may be substantially circular. In an alternative, one or more of the gas outlet, carbon dioxide outlet, and the plasma outlet may be in the shape of a slit.

A portion of the nozzles of the cleaning head may be rotatable about an axis. The rotatable portion of the nozzles may be able to rotate such that the end of the nozzle rotates in a circular path substantially parallel to the plane of the local surface to be cleaned.

The cleaning head may also comprise an acid outlet. The acid outlet may allow ultrasonically activated acid to pass therefrom.

According to a further aspect of the present invention, the method further comprises providing a carbon dioxide stream and providing a stream of extreme clean dry air comprising fewer than 100 particles per cubic meter, directing the carbon dioxide stream to a surface to be cleaned, wherein the stream of extreme clean dry air is configured to provide a protective atmosphere around the surface to be cleaned preventing particles being deposited onto the cleaned surface.

Since the extreme clean dry air is substantially free of any particles, it does not introduce any new contaminants onto a surface which has been cleaned. Preferably, the extreme clean dry air has a level of particles which is less than the level in the surrounding atmosphere. Preferably the extreme clean dry air comprises substantially no water vapour. Since the extreme clean dry air (XCDA) is provided, this causes a general outflow of gases away from the surface and thereby prevents the surrounding atmosphere, which may contain contaminants, from coming into contact with the surface. Reference to CDA is to be interpreted as reference to XCDA. Preferably, the XCDA comprises fewer than 10 particles per cubic meter. Preferably, the particles are less than 0.3 microns, preferably less than 0.2 microns, more preferably less than 0.1 microns, and even more preferably less than 0.01 microns in size.

The XCDA may also serve to dilute the carbon dioxide and thereby reduce the potential risk of danger to the operator by asphyxiation.

The method may further comprise providing a gas evacuation unit to withdraw at least a portion of the carbon dioxide gas and XCDA provided. In this way, any entrained contaminants are removed thereby preventing the contaminants being deposited once again. In order to provide a general flow of gas away from the surface to be cleaned to prevent contamination through exposure of the surface to the surrounding atmosphere, the rate at which gas is removed by the gas evacuation unit is preferably the same as or less than the rate at which gas is provided in the form of carbon dioxide and XCDA. In this way, there remains a general flow of gas away from the surface. If the evacuation unit had a higher removal rate, this could risk less clean atmospheric air reaching the surface.

The method of the present invention may also comprise providing an ionizing unit. The ionizing unit may be any unit which is configured to prevent or eliminate charge build up in the apparatus. An ionizing light source may be provided that directs ionizing radiation to any surface on which charge is generated during operation. The ionizing unit may be provided on or adjacent a nozzle providing the XCDA and/or may be provided in relation to the surface such that the ionizing unit is able to prevent charge build up on the surface.

The method may further comprise providing an enclosure which substantially surrounds the surface to be cleaned. In order to prevent contamination of surfaces other than the one being cleaned, the working parts of the cleaning apparatus, namely the nozzles through which the carbon dioxide and XCDA are supplied, may be surrounded by an enclosure. The enclosure may be provided with a filtering unit. The filtering unit which allows the passage of gases into and out of the enclosure, but does not allow the passage of particles or contaminants. In this way, the pressure within the enclosure may be controlled and prevented from becoming too high.

An apparatus for cleaning a surface comprising at least one carbon dioxide snow outlet, at least one extreme clean dry air outlet, at least one gas evacuation unit and at least one ionization unit, may be employed.

The apparatus may further comprise an enclosure. The enclosure may contain the at least one carbon dioxide snow outlet, the at least one extreme clean dry air outlet, the at least one gas evacuation unit and the at least one ionization unit. The enclosure may comprise a filtering unit.

The XCDA outlet and/or the carbon dioxide snow outlet are preferably moveable. This allows the streams of carbon dioxide and XCDA to be provided at different angles and positions with respect to the surface to be cleaned to allow proper cleaning of the surface.

In an example, the XCDA outlet and the carbon dioxide snow outlet are integrated into a single unit. The carbon dioxide snow outlet may be configured to dispense the carbon dioxide into the XCDA within the unit. The use of XCDA means that no water ice is formed and the carbon dioxide snow is formed in an environment which is substantially free of particles which could contaminate the surface to be cleaned. The resulting carbon dioxide snow stream is also more homogenous and to reduce the cold flux caused by the carbon dioxide stream on the surface to be cleaned. In addition, the size and weight of the carbon dioxide snow particles is reduced such that there is less risk of damage to coatings or fine structures. The single unit may be configured to apply a swirl component to the stream exiting the unit.

As such, there is also provided a nozzle unit comprising a carbon dioxide outlet configured to dispense liquid carbon dioxide into a chamber within the nozzle unit, wherein the chamber is in fluid communication with an XCDA source.

The cleaning heads described in the present disclosure may be used in any of the methods or apparatuses described herein. Any referral to outlets in the present disclosure is intended to encompass the cleaning heads described herein. Outlets may also be referred to as nozzles. The nozzle unit described herein may be used in any example or embodiment described herein.

### BRIEF DESCRIPTION OF THE DRAWINGS

Examples and embodiments will now be described, by way of example only, with reference to the accompanying schematic drawings, in which:
- Figure 1 depicts a lithographic system comprising a lithographic apparatus and a radiation source, parts of which may be cleaned using the apparatus and/or methods described herein;
- Figure 2 is a schematic depiction of the carbon dioxide snow cleaning apparatus;
- Figure 3 depicts another example of the carbon dioxide snow cleaning apparatus;
- Figure 4 depicts a cleaning head comprising a carbon dioxide snow outlet in the form of a slit;
- Figure 5 is a schematic depiction of a cleaning apparatus head;
- Figure 6 is a schematic depiction of a cleaning apparatus head;
- Figure 7 is a schematic depiction of a cleaning apparatus head;
- Figure 8a and 8b are schematic depictions of a cleaning apparatus;
- Figure 9 is a schematic depiction of a cleaning apparatus head;
- Figure 10 is a schematic depiction of a cleaning apparatus head;
- Figure 11 is a schematic depiction of a cleaning; and
- Figure 12 is a schematic depiction of a combined carbon dioxide and XCDA nozzle unit.

### DETAILED DESCRIPTION

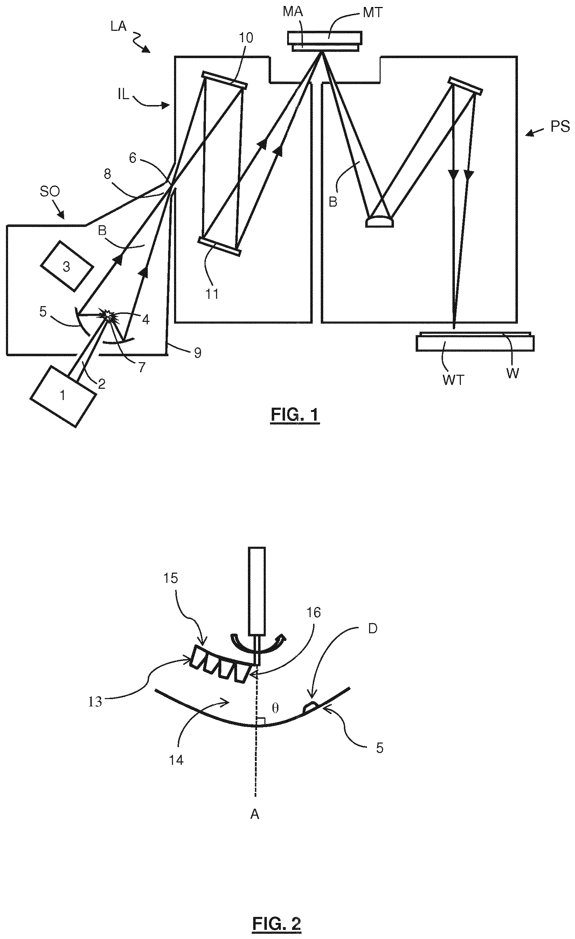

Figure 1 shows a lithographic system including a collector 5 which may become contaminated with tin and thereby require cleaning using the apparatus or methods of the present disclosure and/or invention. The lithographic system comprises a radiation source SO and a lithographic apparatus LA. The radiation source SO is configured to generate an extreme ultraviolet (EUV) radiation beam B. The lithographic apparatus LA comprises an illumination system IL, a support structure MT configured to support a patterning device MA (e.g. a mask), a projection system PS and a substrate table WT configured to support a substrate W. A layer of the resist composition is provided on the substrate W. The illumination system IL is configured to condition the radiation beam B before it is incident upon the patterning device MA. The projection system is configured to project the radiation beam B (now patterned by the mask MA) onto the substrate W. The substrate W may include previously formed patterns. Where this is the case, the lithographic apparatus aligns the patterned radiation beam B with a pattern previously formed on the substrate W.

The radiation source SO, illumination system IL, and projection system PS may all be constructed and arranged such that they can be isolated from the external environment. A gas at a pressure below atmospheric pressure (e.g. hydrogen) may be provided in the radiation source SO. A vacuum may be provided in illumination system IL and/or the projection system PS. A small amount of gas (e.g. hydrogen) at a pressure well below atmospheric pressure may be provided in the illumination system IL and/or the projection system PS.

The radiation source SO shown in Figure 1 is of a type which may be referred to as a laser produced plasma (LPP) source. A laser 1, which may for example be a CO₂ laser, is arranged to deposit energy via a laser beam 2 into a fuel, such as tin (Sn) which is provided from a fuel emitter 3. Although tin is referred to in the following description, any suitable fuel may be used. The fuel may for example be in liquid form, and may for example be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a plasma 7 at the plasma formation region 4. Radiation, including EUV radiation, is emitted from the plasma 7 during de-excitation and recombination of ions of the plasma.

The EUV radiation is collected and focused by a near normal incidence radiation collector 5 (sometimes referred to more generally as a normal incidence radiation collector). The collector 5 may have a multilayer structure which is arranged to reflect EUV radiation (e.g. EUV radiation having a desired wavelength such as 13.5 nm). The collector 5 may have an elliptical configuration, having two ellipse focal points. A first focal point may be at the plasma formation region 4, and a second focal point may be at an intermediate focus 6, as discussed below. Due to the way in which the EUV radiation is generated, the collector 5 may be contaminated with tin, which will reduce its reflectivity and thereby lower the power output of the apparatus.

The laser 1 may be separated from the radiation source SO. Where this is the case, the laser beam 2 may be passed from the laser 1 to the radiation source SO with the aid of a beam delivery system (not shown) comprising, for example, suitable directing mirrors and/or a beam expander, and/or other optics. The laser 1 and the radiation source SO may together be considered to be a radiation system.

Radiation that is reflected by the collector 5 forms a radiation beam B. The radiation beam B is focused at point 6 to form an image of the plasma formation region 4, which acts as a virtual radiation source for the illumination system IL. The point 6 at which the radiation beam B is focused may be referred to as the intermediate focus. The radiation source SO is arranged such that the intermediate focus 6 is located at or near to an opening 8 in an enclosing structure 9 of the radiation source.

The radiation beam B passes from the radiation source SO into the illumination system IL, which is configured to condition the radiation beam. The illumination system IL may include a facetted field mirror device 10 and a facetted pupil mirror device 11. The faceted field mirror device 10 and faceted pupil mirror device 11 together provide the radiation beam B with a desired cross-sectional shape and a desired angular distribution. The radiation beam B passes from the illumination system IL and is incident upon the patterning device MA held by the support structure MT. The patterning device MA reflects and patterns the radiation beam B. The illumination system IL may include other mirrors or devices in addition to or instead of the faceted field mirror device 10 and faceted pupil mirror device 11.

Following reflection from the patterning device MA the patterned radiation beam B enters the projection system PS. The projection system comprises a plurality of mirrors which are configured to project the radiation beam B onto a substrate W held by the substrate table WT. The projection system PS may apply a reduction factor to the radiation beam, forming an image with features that are smaller than corresponding features on the patterning device MA. A reduction factor of 4 may for example be applied. Although the projection system PS has two mirrors in Figure 1, the projection system may include any number of mirrors (e.g. six mirrors).

The radiation sources SO shown in Figure 1 may include components which are not illustrated. For example, a spectral filter may be provided in the radiation source. The spectral filter may be substantially transmissive for EUV radiation but substantially blocking for other wavelengths of radiation such as infrared radiation.

The term "EUV radiation" may be considered to encompass electromagnetic radiation having a wavelength within the range of 4-20 nm, for example within the range of 13-14 nm. EUV radiation may have a wavelength of less than 10 nm, for example within the range of 4-10 nm such as 6.7 nm or 6.8 nm.

Although Figure 1 depicts the radiation source SO as a laser produced plasma LPP source, any suitable source may be used to generate EUV radiation. For example, EUV emitting plasma may be produced by using an electrical discharge to convert fuel (e.g. tin) to a plasma state. A radiation source of this type may be referred to as a discharge produced plasma (DPP) source. The electrical discharge may be generated by a power supply which may form part of the radiation source or may be a separate entity that is connected via an electrical connection to the radiation source SO.

Figure 2 shows a schematic illustration of a carbon dioxide cleaning apparatus in cross-section. A carbon dioxide source (not shown), which may be a cylinder of liquid carbon dioxide, is attached to a carbon dioxide snow outlet 13. As a carbon dioxide stream passes out of the outlet 13, the liquid carbon dioxide expands and at least partially freezes forming a carbon dioxide snow stream 14. A gas stream (not shown) is provided substantially surrounding the carbon dioxide snow stream 14 leaving the outlet 13. The gas stream assists in accelerating the carbon dioxide snow stream 14. The gas stream is heated to around 50°C and the distance between the carbon dioxide snow nozzle 13 and the collector 5 is substantially around 60 mm. The pressure of the gas stream is substantially around 10 bar. The angle θ between the direction of the carbon dioxide snow stream 14 and the surface of the collector 5 is preferably substantially around 90°. The gas stream which substantially surrounds the carbon dioxide snow stream 14 is preferably heated to around 50°C.

The carbon dioxide snow cleaning apparatus comprises an arm 15 which supports the carbon dioxide snow outlets 13. As shown in Figure 2, the arm is shaped such that it substantially corresponds to the shape of the surface which is being cleaned. In particular, the arm is shaped so that the carbon dioxide snow outlets 13 generally follow the shape of the surface to be cleaned. In the embodiment shown in Figure 2, the surface to be cleaned is an EUV collector, and so the arm is shaped to substantially correspond to the surface of the collector. This allows the distance between the surface to be cleaned and the outlet to be the same for each outlet. One or both of the arm 15 and the surface to be cleaned 5 are rotatable. As shown in Figure 2, the arm 15 is attached to a means for rotating the arm 15, which may be, for example, an electric motor (not shown). The surface to be cleaned 5 may be held in a support or cradle (not shown), which may be rotated using any suitable means, for example, an electric motor. The axis of rotation A may be concentric with the collector 5.

Where there is a plurality of carbon dioxide outlets 13, they may be individually controlled so that they can be turned on and off independent of the other carbon dioxide outlets 13. The outlets 13 may also be individually controlled to vary the amount of carbon dioxide snow provided by each outlet 13.

The arm 15 may be linearly movable so that it is able to move along a radius of the collector 5 whilst the collector 5 rotates. The arm 15 may be moved by a linear actuator. Additionally or alternatively, the surface to be cleaned 5 may be linearly movable so that it is able to move in any direction in a plane substantially perpendicular to the axis of rotation. By moving the arm and/or the surface to be cleaned relative to one another, it is possible to ensure that substantially all of the surface to be cleaned passes under at least one of the carbon dioxide snow outlets 13 during cleaning.

The apparatus also comprises at least one plasma outlet 16. As shown in Figure 2, the plasma outlets 16 are located on the same arm 15 as the carbon dioxide outlets 13. However, it will be appreciated that they may be located on a separate arm. In addition, the plasma and carbon dioxide outlets are shown as being in a side-by-side configuration, although it will be appreciated that other configurations, such as in-line, may be used. The carbon dioxide and plasma outlets may be integrated into a single cleaning head.

In use, one or both of the arm 15 and the collector 5 are rotated. The speed of rotation is controlled to ensure that any given point passes through the carbon dioxide snow quickly enough that the given point is not overcooled, but slowly enough to allow the carbon dioxide snow to remove at least a portion of the contaminant. The preferred rate is around 50 mm/s. Since arm and/or the collector are rotating, the angular speed of the outer end of the arm and/or the collector is higher than the angular speed of an inner portion of the arm and/or the collector. As such, the speed of rotation can be varied and the carbon dioxide snow outlets can be turned on or off to ensure optimal cleaning of the surface. The exact rate at which the arm and/or the collector are rotated as well as the length of time the carbon dioxide snow outlets are turned on or off may be determined routinely.

Taking the case where the arm is rotated and the collector is kept stationary, as one of the plurality of carbon dioxide snow outlets moves across the surface of the collector towards a contaminant D, a first portion of the gas stream which substantially surrounds the carbon dioxide snow stream from the carbon dioxide snow outlet passes over the contaminant D and heats the contaminant D. This causes the contaminant D to expand as it heats up. The contaminant D will heat up more quickly than the underlying collector 5 meaning that they will expand at different rates, thus loosening the bond between the contaminant D and the surface of the collector 5. As the apparatus continues to pass across the surface of the collector 5, as the carbon dioxide snow comes into contact with contaminant D, this will rapidly cool the contaminant D and further weaken the bond between the contaminant D and the surface of the collector 5. The carbon dioxide snow may also physically dislodge the contaminant D and push it away from the surface of the collector 5. The carbon dioxide snow removes an oxide layer from the contaminant D to leave a fresh surface on the contaminant D. As the apparatus continues to pass across the surface of the collector 5, a second portion of the gas stream substantially surrounding the carbon dioxide snow stream will pass across the area where the contaminant D was previously located and will warm the surface of the collector 5 up in order to avoid overcooling of the collector 5 and possible water ice or condensation formation.

As the collector 5 continues to rotate, the contaminant, if any remains, will pass under a plasma outlet. The stream of plasma from the plasma outlet will oxidise the contaminant. As the collector continues to rotate, the oxidised contaminant will pass under a carbon dioxide snow cleaning outlet, where it will be cleaned. This process will be repeated as the arm 15 and/or the collector 5 continues to rotate.

Depending on the rate at which oxidation of the contaminant takes place, the apparatus may be turned off to allow the contaminant to oxidise in the air. Alternatively, where the oxidation takes place rapidly, the arm may be allowed to continue to rotate so that it makes multiple passes over the surface of the collector.

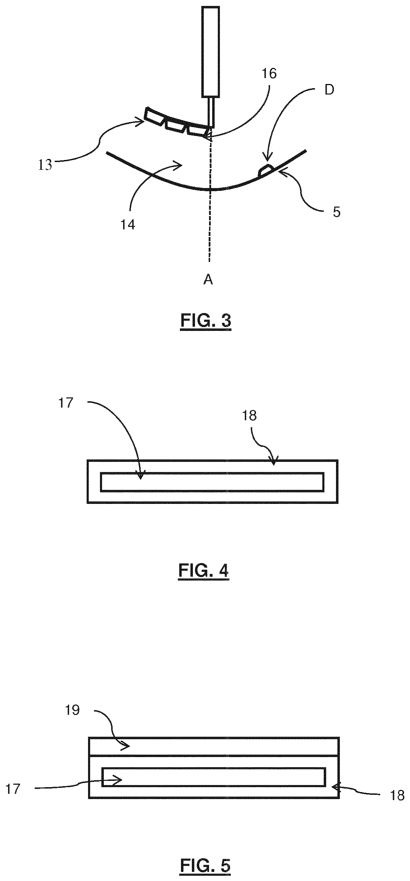

Figure 3 is a schematic illustration of an apparatus similar to that of Figure 2, but wherein the carbon dioxide snow and/or plasma outlets are in the shape of slits, rather than being substantially circular.

Figure 4 depicts a carbon dioxide snow outlet which is shaped as a slit. As can be seen, the inner portion 17 is the area from which the carbon dioxide snow is released and this is surrounded by an outlet 18 for the clean, dry air.

Figure 5 depicts a cleaning head which comprises a carbon dioxide snow slit 17 surrounded by a clean, dry air outlet 18, and adjacent a plasma outlet 19. As will be appreciated, the contaminant can be passed under this cleaning head in either direction.

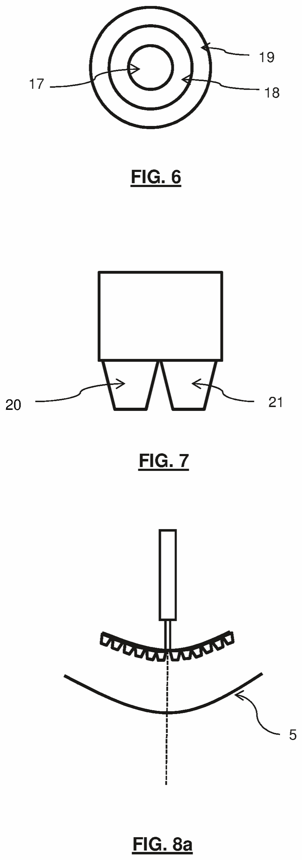

Alternative cleaning heads are also shown in Figures 6, 7, 9, and 10.

In Figure 6, the cleaning head comprises concentric outlets for the carbon dioxide snow 17, clean, dry air 18, and plasma 19. The various outlets are combined into a single nozzle.

In Figure 7, the head comprises a combined carbon dioxide snow and clean, dry air nozzle 20, and a separate plasma nozzle 21.

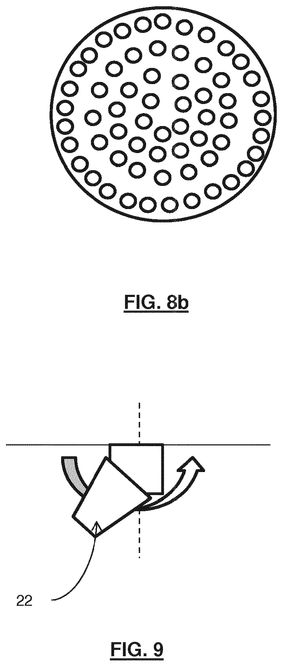

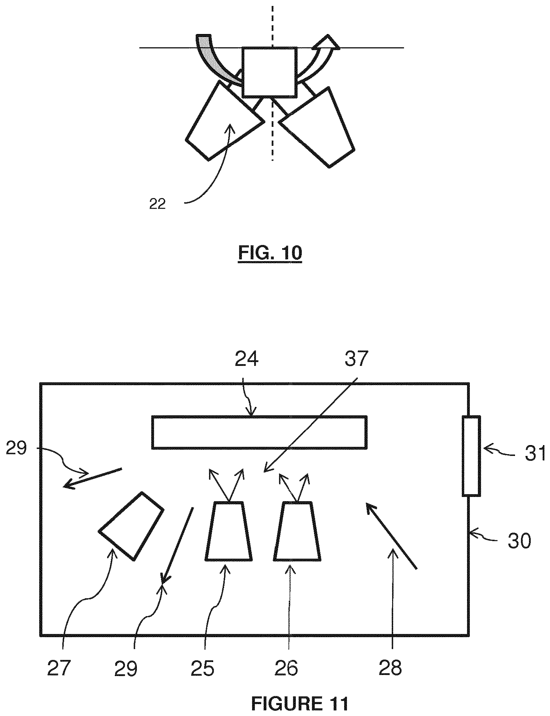

Figures 9 and 10 depict alternative cleaning heads. The cleaning nozzle 22 may be able to rotate about an axis such that the streams leaving the nozzle are directed in a circular pattern. This has the benefit of a single nozzle covering a greater area of the surface to be cleaned. The cleaning head in Figure 9 has a single nozzle, but, as illustrated in Figure 10, there may be more than one nozzle.

It will be appreciated that any of the cleaning heads illustrated or described herein may also comprise an acid outlet. The acid outlet may be instead of or in addition to any of the other types of outlet.

The cleaning heads illustrated and described herein may be used in any of the methods and apparatus illustrated and described herein.

Finally, Figures 8a and 8b depict a 'showerhead' example in which the various outlets are arranged on a plate 23. The plate 23 is shaped to substantially correspond to the shape of the collector 5 to ensure that the distance between the cleaning heads and the surface of the collector 5 is constant over the whole surface of the collector 5. This example may allow substantially the entire surface of the collector 5 to be cleaned at once.

Figure 11 is a schematic depiction of an apparatus depicting a surface 24 to be cleaned.

A carbon dioxide snow outlet 25 is provided which is configured to provide a stream of carbon dioxide snow towards the surface 24. The carbon dioxide snow outlet 25 is attached to a carbon dioxide source (not shown). XCDA outlet 26 is also provided and is configured to provide XCDA. An evacuation unit 27 is provided in order to withdraw at least a portion of the carbon dioxide, XCDA and any entrained contaminants. An ionization unit 28 is also provided to prevent the build-up of electric charge. Due to the nature of the cleaning method used, charges can be generated which can build up and cause contaminants to affix to surfaces or could even result in an electrical discharge which could cause damage. Not all of the carbon dioxide, XCDA and entrained contaminants will be withdrawn by the evacuation unit 27 and some will move away from the surface, shown schematically by arrows 29.

There is also provided an enclosure 30 which surrounds the other parts of the apparatus. The enclosure 30 comprises a filter unit 31 which allows for the passage of gases, but not contaminants. It will be appreciated that the carbon dioxide and XCDA sources may be provided by conduits which pass through an opening in the enclosure 30. Preferably the enclosure 30 is substantially gas tight, with the exception of the filter unit 31.

In use, carbon dioxide snow is provided from carbon dioxide outlet 25 into zone 37. The carbon dioxide snow impacts upon the surface 24 and dislodges contaminants. XCDA is provided from the XCDA outlet 26 into zone 37. The evacuation unit 27 withdraws the carbon dioxide, XCDA and entrained contaminants. Due to the supply of XCDA, there is a general outflow of gases and contaminants from the surface 24 as shown by arrows 29 which prevents contaminated air from coming into contact with surface 24. The ionisation unit 28 is configured to prevent the build-up of charge on the surface 24, the carbon dioxide outlet 25, the XCDA outlet 26, or any other element on which charge may build. The ionisation unit 28 may be operated continuously or intermittently. The evacuation unit 27 may be in fluid communication with a vacuum line in order to provide an area of lower pressure towards which the gases and entrained contaminants flow.

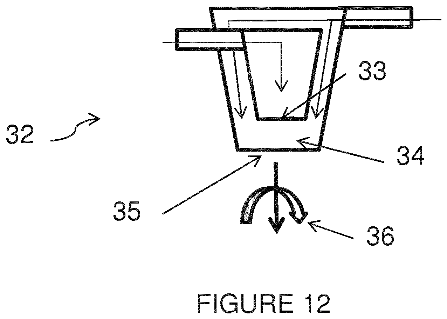

Figure 12 is a schematic depiction of a nozzle unit 32. The nozzle unit 32 comprises a carbon dioxide snow outlet 33 that discharges carbon dioxide, preferably in liquid form, into chamber 34. Chamber 34 is also in fluid communication with an XCDA source such that the carbon dioxide is discharged into an atmosphere of XCDA. The combined stream of carbon dioxide and XCDA exits the nozzle unit 32 through nozzle unit outlet 35 and is directed towards a surface to be cleaned (not shown). The nozzle unit 32 may be configured to provide a swirl component 36 to the combined stream. This may be achieved by any suitable means. In this configuration, the liquid carbon dioxide is formed into carbon dioxide snow in an atmosphere of XCDA which prevents any contaminants present in the atmosphere from being incorporated into the carbon dioxide snow.

The present example utilises operating conditions which go against the common general knowledge in the field with respect to the distance between the carbon dioxide nozzle and the surface to be cleaned, and the angle at which the carbon dioxide snow stream is incident on the surface to be cleaned. Each of these parameters results in improved cleaning performance when compared to the parameters of the prior art. Further, the combination of a cooperative robot with a carbon dioxide snow cleaning apparatus surprisingly allows improved cleaning performance when compared to existing systems. Furthermore, this combination allows collectors of EUV lithographic apparatus to be cleaned without the risk of damage. In addition, the combination of a hydrochloric acid stream and an ultrasonic transducer improves the cleaning performance of just hydrochloric acid alone.

## Claims

1. A method of cleaning a surface to remove a metallic contaminant (D) therefrom, the method comprising:
- a first carbon dioxide snow cleaning step in which a stream (14) of carbon dioxide snow is passed over the metallic contaminant (D), and
- an oxidation step;
**characterized in that** the oxidation step is subsequent to the first carbon dioxide snow cleaning step, whereby in the first carbon dioxide snow cleaning step any existing oxide layer is removed from the metallic contaminant thereby exposing a non-oxidized layer of the metallic contaminant, and whereby in the oxidation step an oxidized metallic contaminant is formed by oxidizing at least a portion of the exposed non-oxidized layer of the metallic contaminant, and the method further comprising:
- a subsequent carbon dioxide snow cleaning step in which a stream (14) of carbon dioxide snow is passed over the oxidized metallic contaminant.

2. A method according to claim 1, wherein the metallic contaminant comprises one or more metals and metal compounds.

3. A method according to any of Claims 1 and 2, wherein the metallic contaminant comprises tin.

4. A method according to any of Claims 1 to 3, wherein the at least a portion of the non-oxidized layer of the metallic contaminant is oxidized by exposure to plasma.

5. A method according to Claim 4, wherein the plasma is atmospheric plasma.

6. A method according to any of Claims 4 and 5, wherein the plasma comprises oxygen.

7. A method according to any of Claims 4 to 6, wherein using clean dry air to generate the plasma.

8. A method according to any of Claims 4 to 7, wherein the plasma is provided via at least one plasma outlet (16), preferably a plurality of plasma outlets, and wherein at least one carbon dioxide snow outlet (13,17,20) is positioned adjacent the at least one plasma outlet (16,19,21) and/or may be positioned in line with the at least one plasma outlet (16).

9. A method according to any preceding claim, wherein the oxidation step and the subsequent carbon dioxide snow cleaning step are repeated.

10. A method according to any preceding claim, wherein the stream (14) of carbon dioxide snow is provided via a plurality of carbon dioxide snow outlets (13,17,20) and wherein the plurality of carbon dioxide snow outlets are provided on an arm (15).

11. A method according to Claim 10, wherein the method further comprises rotating the arm (15) relative to the surface to be cleaned and/or rotating the surface to be cleaned relative to the arm (15).

12. A method according to any previous claim, wherein the surface to be cleaned is the surface of an EUV collector (5).

13. A method for cleaning the surface to remove the metallic contaminant therefrom comprising providing the stream (14) of carbon dioxide snow and providing a stream of extreme clean dry air comprising fewer than 100 particles per cubic meter, directing the stream (14) of carbon dioxide snow to the surface (24) to be cleaned, wherein the stream of extreme clean dry air is configured to provide a protective atmosphere around the surface (24) to be cleaned preventing particles being deposited onto the cleaned surface, said method further including the steps of any of claims 1 to 12.

14. A method according to Claim 13, the method further comprising providing a gas evacuation unit (27) to withdraw at least a portion of a carbon dioxide gas and extreme clean dry air provided.

15. A method according to Claim 13 or 14, further comprising providing an ionization unit (28) to prevent or eliminate build-up of electric charge.

## Patentansprüche

1. Ein Verfahren zum Reinigen einer Oberfläche, um einen metallischen Verschmutzungsstoff (D) davon zu entfernen, wobei das Verfahren Folgendes beinhaltet:
- einen ersten Kohlendioxidschnee-Reinigungsschritt, in dem ein Strom (14) von Kohlendioxidschnee über den metallischen Verschmutzungsstoff (D) geleitet wird, und
- einen Oxidationsschritt;
**dadurch gekennzeichnet, dass** der Oxidationsschritt auf den ersten Kohlendioxidschnee-Reinigungsschritt nachfolgt, wobei in dem ersten Kohlendioxidschnee-Reinigungsschritt jegliche bestehende Oxidschicht von dem metallischen Verschmutzungsstoff entfernt wird, wodurch eine nicht oxidierte Schicht des metallischen Verschmutzungsstoffs freigelegt wird, und wobei in dem Oxidationsschritt durch Oxidieren mindestens eines Teils der freigelegten nicht oxidierten Schicht des metallischen Verschmutzungsstoffs ein oxidierter metallischer Verschmutzungsstoff gebildet wird, und wobei das Verfahren ferner Folgendes beinhaltet:
- einen nachfolgenden Kohlendioxidschnee-Reinigungsschritt, in dem ein Strom (14) von Kohlendioxidschnee über den oxidierten metallischen Verschmutzungsstoff geleitet wird.

2. Verfahren gemäß Anspruch 1, wobei der metallische Verschmutzungsstoff ein oder mehrere Metalle und Metallverbindungen beinhaltet.

3. Verfahren gemäß einem der Ansprüche 1 und 2, wobei der metallische Verschmutzungsstoff Zinn beinhaltet.

4. Verfahren gemäß einem der Ansprüche 1 bis 3, wobei der mindestens eine Teil der nicht oxidierten Schicht des metallischen Verschmutzungsstoffs oxidiert wird, indem er Plasma ausgesetzt wird.

5. Verfahren gemäß Anspruch 4, wobei das Plasma atmosphärisches Plasma ist.

6. Verfahren gemäß einem der Ansprüche 4 und 5, wobei das Plasma Sauerstoff beinhaltet.

7. Verfahren gemäß einem der Ansprüche 4 bis 6, wobei reine, trockene Luft verwendet wird, um das Plasma zu erzeugen.

8. Verfahren gemäß einem der Ansprüche 4 bis 7, wobei das Plasma über mindestens einen Plasmaauslass (16), vorzugsweise eine Vielzahl von Plasmaauslässen, bereitgestellt wird und wobei mindestens ein Kohlendioxidschneeauslass (13, 17, 20) angrenzend an den mindestens einen Plasmaauslass (16, 19, 21) positioniert ist und/oder in Linie mit dem mindestens einen Plasmaauslass (16) positioniert werden kann.

9. Verfahren gemäß einem der vorhergehenden Ansprüche, wobei der Oxidationsschritt und der nachfolgende Kohlendioxidschnee-Reinigungsschritt wiederholt werden.

10. Verfahren gemäß einem der vorhergehenden Ansprüche, wobei der Strom (14) von Kohlendioxidschnee über eine Vielzahl von Kohlendioxidschneeauslässen (13, 17, 20) bereitgestellt wird und wobei die Vielzahl von Kohlendioxidschneeauslässen auf einem Arm (15) bereitgestellt ist.

11. Verfahren gemäß Anspruch 10, wobei das Verfahren ferner das Drehen des Arms (15) relativ zu der zu reinigenden Oberfläche und/oder das Drehen der zu reinigenden Oberfläche relativ zu dem Arm (15) beinhaltet.

12. Verfahren gemäß einem der vorhergehenden Ansprüche, wobei die zu reinigende Oberfläche die Oberfläche eines EUV-Kollektors (5) ist.

13. Ein Verfahren zum Reinigen der Oberfläche, um den metallischen Verschmutzungsstoff davon zu entfernen, das Folgendes beinhaltet: Bereitstellen des Stroms (14) von Kohlendioxidschnee und Bereitstellen eines Stroms extrem reiner, trockener Luft, die weniger als 100 Teilchen pro Kubikmeter beinhaltet, Lenken des Stroms (14) von Kohlendioxidschnee auf die zu reinigende Oberfläche (24), wobei der Strom extrem reiner, trockener Luft konfiguriert ist, eine schützende Atmosphäre um die zu reinigende Oberfläche (24) bereitzustellen, was verhindert, dass Teilchen auf der gereinigten Oberfläche abgelagert werden, wobei das Verfahren ferner die Schritte gemäß einem der Ansprüche 1 bis 12 umfasst.

14. Verfahren gemäß Anspruch 13, wobei das Verfahren ferner das Bereitstellen einer Gasabführungseinheit (27) zum Absaugen mindestens eines Teils eines Kohlendioxidgases und bereitgestellter extrem reiner, trockener Luft beinhaltet.

15. Verfahren gemäß Anspruch 13 oder 14, das ferner das Bereitstellen einer Ionisationseinheit (28) zum Verhindern oder Beseitigen eines Aufbaus elektrischer Ladung beinhaltet.

## Revendications

1. Un procédé de nettoyage d'une surface pour enlever un contaminant métallique (D) de celle-ci, le procédé comprenant :
- une première étape de nettoyage à la neige carbonique dans laquelle un flux (14) de neige carbonique est passé par-dessus le contaminant métallique (D), et
- une étape d'oxydation ;
**caractérisé en ce que** l'étape d'oxydation intervient postérieurement à la première étape de nettoyage à la neige carbonique, grâce à quoi dans la première étape de nettoyage à la neige carbonique toute couche d'oxyde existante est enlevée du contaminant métallique exposant de ce fait une couche non oxydée du contaminant métallique, et grâce à quoi dans l'étape d'oxydation un contaminant métallique oxydé est formé par oxydation d'au moins une portion de la couche non oxydée exposée du contaminant métallique, et le procédé comprenant en sus :
- une étape de nettoyage à la neige carbonique postérieure dans laquelle un flux (14) de neige carbonique est passé par-dessus le contaminant métallique oxydé.

2. Un procédé selon la revendication 1, où le contaminant métallique comprend un ou plusieurs métaux et composés métalliques.

3. Un procédé selon n'importe lesquelles des revendications 1 et 2, où le contaminant métallique comprend de l'étain.

4. Un procédé selon n'importe lesquelles des revendications 1 à 3, où l'au moins une portion de la couche non oxydée du contaminant métallique est oxydée par exposition à un plasma.

5. Un procédé selon la revendication 4, où le plasma est un plasma atmosphérique.

6. Un procédé selon n'importe lesquelles des revendications 4 et 5, où le plasma comprend de l'oxygène.

7. Un procédé selon n'importe lesquelles des revendications 4 à 6, où il est utilisé de l'air sec propre pour générer le plasma.

8. Un procédé selon n'importe lesquelles des revendications 4 à 7, où le plasma est fourni via au moins une sortie de plasma (16), préférablement une pluralité de sorties de plasma, et où au moins une sortie de neige carbonique (13, 17, 20) est positionnée adjacente à l'au moins une sortie de plasma (16, 19, 21) et/ou peut être positionnée en ligne avec l'au moins une sortie de plasma (16).

9. Un procédé selon n'importe quelle revendication précédente, où l'étape d'oxydation et l'étape de nettoyage à la neige carbonique postérieure sont répétées.

10. Un procédé selon n'importe quelle revendication précédente, où le flux (14) de neige carbonique est fourni via une pluralité de sorties de neige carbonique (13, 17, 20) et où la pluralité de sorties de neige carbonique sont fournies sur un bras (15).

11. Un procédé selon la revendication 10, où le procédé comprend en sus le fait de faire tourner le bras (15) par rapport à la surface à nettoyer et/ou le fait de faire tourner la surface à nettoyer par rapport au bras (15).

12. Un procédé selon n'importe quelle revendication précédente, où la surface à nettoyer est la surface d'un collecteur EUV (5).

13. Un procédé pour le nettoyage de la surface afin d'enlever le contaminant métallique de celle-ci comprenant le fait de fournir le flux (14) de neige carbonique et de fournir un flux d'air sec ultra propre comprenant moins de 100 particules par mètre cube, en dirigeant le flux (14) de neige carbonique sur la surface (24) à nettoyer, où le flux d'air sec ultra propre est configuré pour fournir une atmosphère protectrice autour de la surface (24) à nettoyer empêchant que des particules ne soient déposées sur la surface nettoyée, ledit procédé incluant en sus les étapes de n'importe lesquelles des revendications 1 à 12.

14. Un procédé selon la revendication 13, le procédé comprenant en sus le fait de fournir une unité d'évacuation de gaz (27) pour retirer au moins une portion d'un gaz carbonique et de l'air sec ultra propre fournis.

15. Un procédé selon la revendication 13 ou 14, comprenant en sus le fait de fournir une unité d'ionisation (28) pour empêcher ou éliminer une accumulation de charge électrique.
